Europäisches Patentamt

European Patent Office

Office européen des brevets

(19)

(11) Publication number: **0 253 512**
**A2**

(12) # EUROPEAN PATENT APPLICATION

(21) Application number: **87305365.6**

(22) Date of filing: **17.06.87**

(51) Int. Cl.4: **C30B 9/00 , C30B 29/32**

(30) Priority: **17.06.86 US 875155**

(43) Date of publication of application:
**20.01.88 Bulletin 88/03**

(84) Designated Contracting States:
**DE FR GB IT**

(71) Applicant: **WESTINGHOUSE ELECTRIC CORPORATION**
**Westinghouse Building Gateway Center**
**Pittsburgh Pennsylvania 15222(US)**

(72) Inventor: **Partlow, Deborah Paruso**
**450 Maple Avenue**
**Swissvale PA 15218(US)**
Inventor: **Bratton, Raymond Joseph**
**445 Manor Road**
**Delmont PA 15626(US)**

(74) Representative: **van Berlyn, Ronald Gilbert**
**23, Centre Heights**
**London, NW3 6JG(GB)**

(54) **Preparation of lead titanate for use in piezoelectric composite transducers.**

(57) PbTiO₃ crystals are produced for mixing with a flexible host material to form a flexible hydrophone element. The crystals are grown by heating the PbTiO₃ in the presence of PbO to a desired average grain size of approximately 8-15 µm. The crystals are thereafter etched to result in an average grain size of approximately 12-20 µm with a relatively narrow grain size distribution.

FIG. 5

EP 0 253 512 A2

# PREPARATION OF LEAD TITANATE FOR USE IN PIEZOELECTRIC COMPOSITE TRANSDUCERS

The invention broadly relates to underwater transducers, and particularly to a piezoelectric material which allows for a higher transducer sensitivity.

In the detection of distant underwater targets, use is made of a passive array of hydrophones. In general the larger the array aperture, the greater will be its ability to accurately determine target location. If the array is carried by an underwater vessel such as a submarine, the array should be conformable to the submarine's shape so as not to interfere with its hydrodynamic design.

One type of material which exhibits excellent piezoelectric properties is lead titanate ($PbTiO_3$), however, it is extremely difficult to form the crystals into a solid ceramic article for conformable, or even non-conformable use. Accordingly, the $PbTiO_3$ is commonly used in a powder form by embedding it in a suitable matrix material such as neoprene rubber. After application of suitable electrodes and poling, the arrangement serves as a flexible transducer for a conformable array.

One such transducer is described in German Patent 2922260. A process is described for producing $PbTiO_3$, or the like, which results in an extremely fine powder of narrow grain size distribution. In contrast, it is a principal object of the present invention to provide a process which results in a much larger average grain size with a fairly narrow size distribution resulting in more desirable transducer characteristics. With the larger size $PbTiO_3$ crystals, the surface area to volume ratio is much smaller and, in those composites where flexibility is not of prime consideration, allows for the increase of volume percent of $PbTiO_3$.

A method of preparing a piezoelectric powder for fabrication into a transducer is described and comprises the steps of growing $PbTiO_3$ crystals by heating a $PbTiO_3$ crystal producing powder in the presence of excess PbO. The powder may be $PbTiO_3$ itself or the unreacted oxides of Pb and Ti, that is, lead oxide and titanium dioxide with the excess Pb taking the form of PbO. The crystals are grown so as to have an average equivalent spherical diameter grain size of approximately 8-15 $\mu m$ and a grain size distribution, between 10% and 90%, of a maximum grain size of approximately 2.5 times the average and a minimum grain size of approximately 0.3 times the average.

The grown crystals are etched, to smooth the surfaces and remove extra-fine particles, for a time period to create an average equivalent spherical diameter grain size of approximately 12-20 $\mu m$ and a grain size distribution, between 10% and 90%, of a maximum grain size of not more than approximately 1.3 times the average and a minimum grain size of not less than approximately 0.6 times the average. After the etching step, the etched crystals are rinsed and dried and constitute one ingredient in the fabrication of a flexible transducer having a host material such as neoprene rubber.

The preferred embodiment of the invention will now be described, by way of example, with reference to the accompanying drawings, in which

Figure 1 illustrates the steps involved in the preparation of transducer active material in accordance with one embodiment of the present invention;

Figure 2 illustrates a transducer made with the material resulting from the steps of Figure 1;

Figure 3 presents a set of curves relative to several preparation steps of Figure 1;

Figures 4A and 4B illustrate, in two different magnifications, the material produced during one point in the process of Figure 1;

Figure 5 is a curve illustrating particle size distribution resulting from the steps of Figure 1; and

Figures 6A and 6B illustrate, in two different magnifications, the powder produced as the result of the steps of Figure 1.

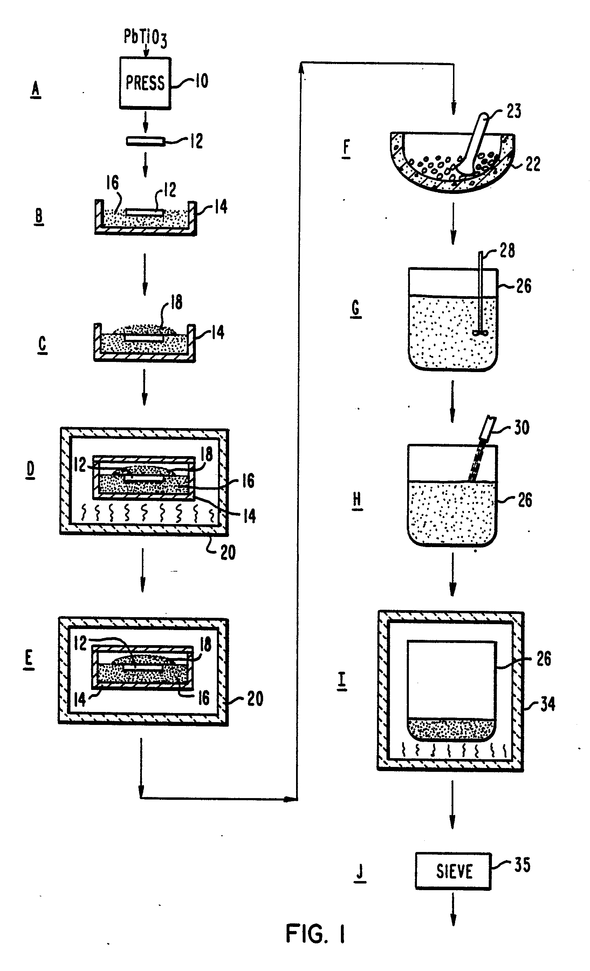

The steps in the preparation of the active transducer powder to be mixed with a flexible host material for making a flexible transducer, is illustrated in Figure 1, by way of example. The starting powder in one embodiment may be a commercially available $PbTiO_3$ having an average grain size of 1.65 microns ($\mu m$) which is put into a press 10, as indicated in step A and compressed into a disk form 12 under approximately 6000 lbs. of pressure.

The disk 12, as indicated in step B, is placed in a high purity aluminum oxide container 14 on a bed of $PbTiO_3$ powder 16 and then covered with a loosely packed layer of lead oxide (PbO) 18 as indicated in step C.

In step D, the container 14 is covered and placed in a furnace 20 at an elevated temperature of approximately 850°C to 1000°C for approximately 2 hours. The purpose of the arrangement is to promote $PbTiO_3$ crystal growth since the initial powder has an undesirably small average particle size (1.65 $\mu m$). The arrangement promotes the vapor phase by having more lead than titanium by the inclusion of the PbO covering 18. The remainder of the disk 12 is surrounded by its own powder to prevent loss of lead out the sides and the bottom. Step D describes a sintering operation wherein the disk is heated, not to its melting point, but to a point where surface atoms can vaporize and redeposit elsewhere to fuse together, resulting in larger crystals. After the sintering operation, the heat is removed, at step E, and the arrangement allowed to cool to room temperature.

After cooling, the disk 12 is gently broken up, without grinding, as indicated at step F. This gentle breaking up, or light pulverization, may be done with a mortar 22 and pestle 23.

The granular material resulting from step F is next subjected to an etching process at step G wherein the powdered material is placed in a container 26 with an equal weight of etchant solution such as 10% nitric acid and wherein the solution is mixed for approximately 5 hours at room temperature by means of stirrer 28.

After the 5-hour time period, and as indicated at step H, the mixture is rinsed with deionized water 30 until an approximately neutral pH value is obtained. Step H may require several rinsings.

The liquid is poured off and the remaining wet powder in beaker 26 is dried, in furnace 34, operating at approximately 100°C. The dried loose powder resulting from step I is then passed through a sieve 35, at step J, to remove undesirably large particles, for example those greater than 90μm.

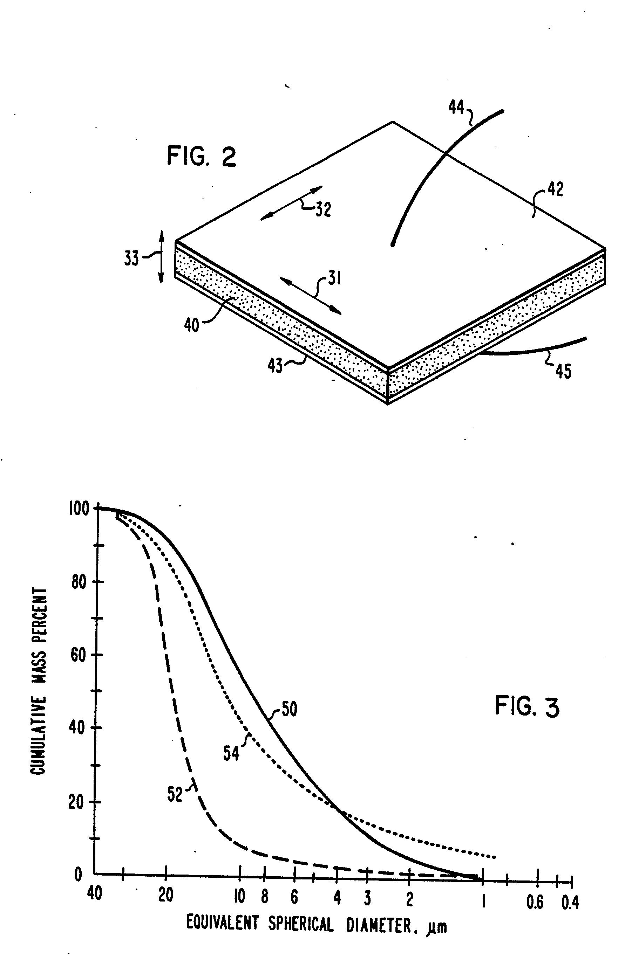

The piezoelectric powder is used in the fabrication of a relatively flexible transducer which is illustrated in Figure 2. As is well known, the piezoelectric powder is mixed with a host material such as neoprene rubber to form a $PbTiO_3$-rubber composite typically including 64 volume percent of $PbTiO_3$. Electrically conducting electrode surfaces 42 and 43 are applied to the top and bottom surfaces of the composite and a suitable electrical connection made to the electrodes by means of conductors 44 and 45. In order to impart transducer characteristics to the arrangement, a DC electrical potential is applied to the leads 44 and 45 to establish a poling field, for example 10,000 volts/mm. of thickness. The direction of poling is designated as the 33 direction, as indicated by the arrow, while the other two mutually perpendicular directions are designated and indicated as the 31 and 32 directions.

In the fabrication of the transducer for use as a hydrophone, it is desired to have as high a sensitivity as possible in order to maximize the output voltage produced by an impinging acoustic signal. To achieve maximum sensitivity, it is desirable that the hydrostatic piezoelectric coefficient $d_h$ be as high as possible where:

$$d_h = d_{33} - (d_{31} + d_{32}) \quad (1)$$

In the equation, $d_{33}$ is the piezoelectric constant or charge coefficient and is a figure of merit relating the ratio of electric charge generated per unit area to the applied force per unit area in the 33 direction, that is, along the polarization axis. In response to an acoustic signal, some charge is generated along the 31 and 32 axes which collectively subtract from the maximum charge along the 33 direction. Therefore, it is seen that to maximize the transducer response, it is desirable that $d_{33}$ be as large as possible. The $PbTiO_3$ powder produced in accordance with the present invention results in an optimization of hydrophone sensitivity.

The referenced patent teaches the fabrication of single domain micro-crystals and graphically depicts a particle size distribution of extremely small size where between 10 and 90% of the particle range from approximately 3.2 μm to approximately 4.8 μm, with an average size of 4 μm, before etching. As contrasted with this range, and with reference back to Figure 1, the process depicted results in an average particle size, after step F, of approximately 8-15 μm with 80% of the particle sizes falling between a maximum of approximately 2.5 times the average to a minimum of approximately 0.3 times the average.

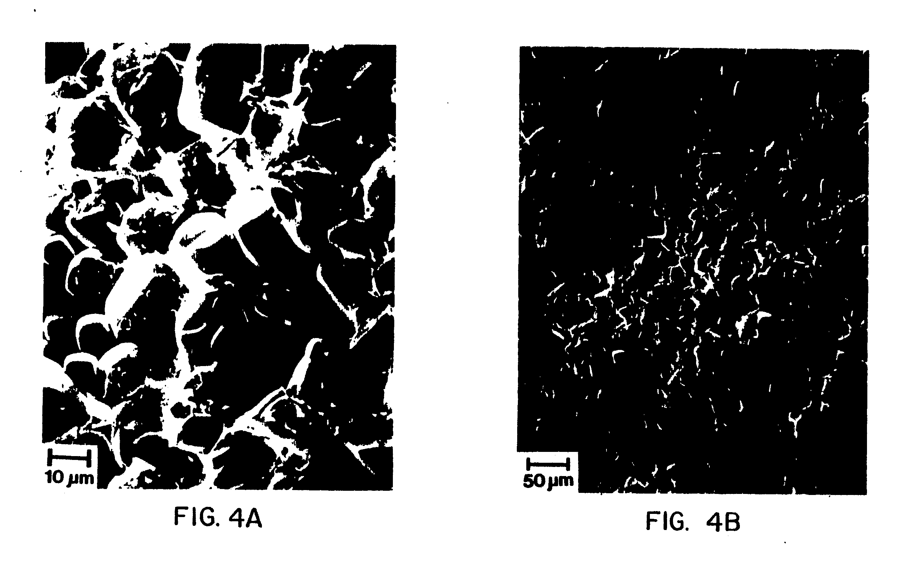

The particle size distribution of the $PbTiO_3$ crystals resulting from step F of Figure 1 is plotted as curve 50 in Figure 3 wherein the equivalent spherical diameter in microns is plotted on the horizontal axis and cumulative mass percent on the vertical axis. For the specific parameters discussed with respect to the steps of Figure 1, the unetched $PbTiO_3$ crystals, from curve 50 have an average particle size (the 50% level) of approximately 9, with a maximum particle size (at the 90% level) of approximately 18 and a minimum particle size (at the 10% level) of approximately 2.8. Figures 4A and 4B are scanning electron micrographs of the $PbTiO_3$ crystals resulting from step F. Figure 4A illustrates relatively large crystals, with the 10 μm mark being used for reference. Figure 4B illustrates a desired uniform morphology on the lower magnification scale, relative to the 50 μm mark.

The etching of step G removes amorphous material which bonds agglomerates together, smooths the surface of the crystals, and dissolves extra-fine particles. The etching also removes glassy material from the surface of the crystals. This glassy material is thought to be oxides of lead and therefore not polarizable.

Curve 52 shows the particle size distribution after etching of the $PbTiO_3$ crystals for 5 hours. It is seen that as a result of the etching step, the average particle size has increased and the particle size distribution has decreased, that is, the slope of the curve between the 10% and 80% levels has become steeper. In a further step to determine the effects of etching, a sample of the powder from step F was etched for 16 hours, the results being illustrated by curve 54 which shows that continued etching past the 5 hours starts to undesirably reduce the average grain size and increase the particle size distribution which, in a theoretically ideal case, would define a vertical line.

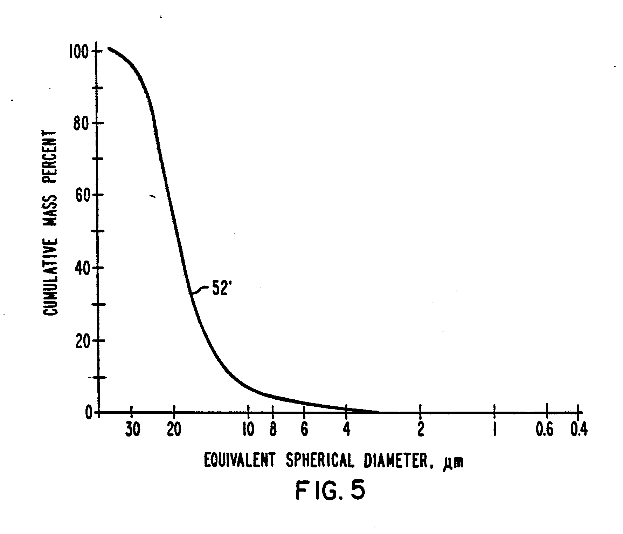

The particle size distribution curves of Figure 3 were automatically plotted by commercially available apparatus which includes a fluid into which a sample of the particles is introduced. During the particle size analysis, some agglomerates are so large that they quickly settled out of suspension before the measurement process could begin. This situation manifests itself as an initial drop in curve 52 at the approximate 35 $\mu$m starting size. These few extra large particles were undesirable and were removed by the sieve 35 of step J of Figure 1 resulting thereafter in curve 52' illustrated in Figure 5 wherein the average particle size is approximately a little over 19 $\mu$m with the maximum at the 90% level being 26 $\mu$m and the minimum at the 10% level being 11.5 $\mu$m.

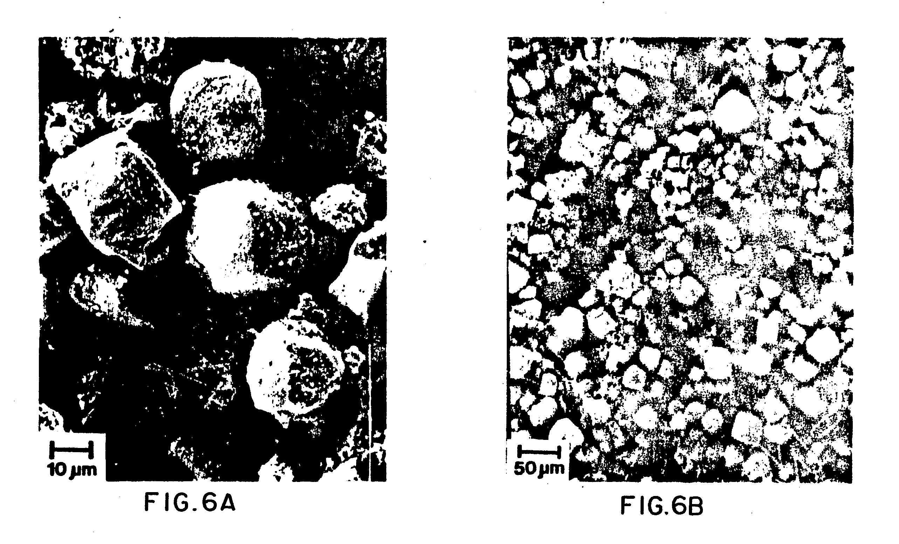

Figures 6A and 6B illustrate scanning electron micrographs of the powder resulting after the etching and screening steps. Figure 6A illustrates, on the 10 $\mu$m scale, the relatively large particles and Figure 6B, on the lower magnification 50 $\mu$m scale, illustrates a fairly uniform size distribution.

The preferred range for the final PbTiO$_3$ powder should have an average grain size from approximately 12 to 20 $\mu$m with a maximum grain size (at the 90% level) of not more than 1.35 times the average size and a minimum grain size (at the 10% level) of not less than 0.6 times the average.

The PbTiO$_3$ crystals are grown and processed, as described, so as to fall within the recited range, which is significantly larger than that described in the referenced patent, but not so large as to be unmixable or to detract from the flexibility of the final composite transducer. The relatively large average size for the crystal is selected in the belief that the material around the surface of the individual crystals is somewhat distorted from the pure crystal structure. Therefore, the greater the surface area per unit volume, the more imperfect crystal material is included, resulting in a less efficient transducer. That is, during the previously applied poling process, the imperfect surface material cannot be properly poled since it does not have the correct crystalline structure to start with and the sensitivity of the transducer depends upon how well the piezoelectric powder can be poled.

Therefore, an object in the processing of the material is to achieve as low a surface area-to-volume ratio as practical. For example, assuming a perfect sphere with a diameter d, the surface area A of the sphere is given as:

$$A = \pi d^2$$

and the volume is:

$$V = \frac{1}{6}\pi d^3$$

In one experiment, a transducer was made in accordance with the teachings herein and included the PbTiO$_3$ crystals with an average particle size of a little over 19 $\mu$m. This was compared with an identical transducer made with a commercially available PbTiO$_3$ powder having an average particle size of 2.5 $\mu$m. The transducer made in accordance with the present invention exhibited a $d_{33}$ of 50 compared with 26 and a $d_h$ of .33 compared with 13.

The surface area-to-volume ratio, therefore, is inversely proportional to the diameter of the sphere, that is $\frac{A}{V} = \frac{k}{d}$. In comparison with the crystal suggested in the referenced patent, the crystals produced in accordance with the present invention have a desirably smaller surface area-to-volume ratio of one-third to one-fifth that of the referenced patent.

Steps A to C of Figure I illustrated the formation of a disk under pressure, the surrounding of the disk with PbTiO$_3$ and the covering of the exposed surface of the disk with PbO. In an alternate embodiment, the disk need not be formed and excess Pb in the form of at least 5 wt.% of PbO may be placed on a starting bed of PbTiO$_3$, or an equimolar mixture of PbO and TiO$_2$.

## Claims

1. A method of preparing a piezoelectric powder in which growing PbTiO$_3$ crystals are grown by heating a PbTiO$_3$ crystal producing powder in the presence of excess PbO characterized by the steps of:

A) growing said crystals so as to have an average equivalent spherical diameter grain size of approximately 8-15 $\mu$m and a grain size distribution, between 10% and 90%, of a maximum grain size of approximately 2.5 times the average and a minimum grain size of approximately 0.3 times the average;

B) etching said grown crystals to smooth the surface thereof and remove extra-fine particles for a time period to create an average equivalent spherical diameter grain size of approximately 12-20 $\mu$m and a grain size distribution, between 10% and 90%, of a maximum grain size of not more than approximately 1.35 times the average and a minimum grain size of not less than approximately 0.6 times the average;

C) rinsing and drying said etched crystals.

2. A method in accordance with claim 1 characterized in:

A) said PbTiO$_3$ crystal producing powder being PbTiO$_3$.

3. A method in accordance with claim 1 characterized in:

A) said PbTiO$_3$ crystal producing powder being a mixture of the unreacted oxides of Pb and Ti.

4. A method in accordance with claim 1 characterized in the step of:

A) initially pressing said powder into a disk.

5. A method in accordance with claim 4 characterized in:

A) is pressing said powder into a disk under a pressure of 6000 lbs.

6. A method in accordance with claim 4 which characterized in the step of:

A) placing said disk onto a bed of $PbTiO_3$ powder and covering with excess PbO prior to heating.

7. A method in accordance with claim 6 characterized in:

A) enclosing said disk, powder and excess PbO within a container.

8. A method in accordance with claim 7 wherein:

A) said container being made of $Al_2O_3$.

9. A method in accordance with claim 7 characterized in the step of:

A) heating said container and its contents at a temperature of approximately 1000°C.

10. A method in accordance with claim 9 characterized in the step of:

A) heating said container and contents for a period of approximately 2 hours and thereafter cooling said container and contents.

11. A method in accordance with claim 1 characterized in the step of:

A) gently breaking up the cooled disk, without grinding.

12. A method in accordance with claim 1 characterized in the step of:

A) immersing the grown crystals in an etchant solution and stirring the solution.

13. A method in accordance with claim 12 characterized in the step of :

A) stirring said solution for 5 hours.

14. A method in accordance with claim 12 characterized in the step of:

A) stirring said solution at room temperature.

15. A method in accordance with claim 1 characterized in the step of:

A) passing said dried crystals through a sieve to remove extra large particles above a predetermined size.

16. A method in accordance with claim 15 characterized in:

A) said predetermined size being approximately 90 $\mu$m.

17. A piezoelectric powder characterized in being produced by the steps of:

A) growing $PbTiO_3$ crystals by heating a $PbTiO_3$ crystal producing powder in the presence of excess PbO;

B) growing said crystals so as to have an average equivalent spherical diameter grain size of approximately 8-15 $\mu$m and a grain size distribution, between 10% and 90%, of a maximum grain size of approximately 2.5 times the average and a minimum grain size of approximately 0.3 times the average;

C) etching said grown crystals to smooth the surface thereof and remove extra-fine particles for a time period to create an average equivalent spherical diameter grain size of approximately 12-20 $\mu$m and a grain size distribution, between 10% and 90%, of a maximum grain size of not more than approximately 1.35 times the average and a minimum grain size of not less than approximately 0.6 times the average;

D) rinsing and drying said etched crystals.

FIG. 1

FIG. 2

CUMULATIVE MASS PERCENT

EQUIVALENT SPHERICAL DIAMETER, μm

FIG. 3

FIG. 4B

50 μm

FIG. 4A

10 μm

FIG. 5

FIG.6A

FIG.6B

0 253 512